# EUROPEAN PATENT APPLICATION

(11) **EP 4 465 369 A1**
(43) Date of publication of application: **20.11.2024**
(21) Application number: 22920523.2
(22) Date of filing: 09.12.2022
(51) Int. Cl.: H01L 33/16, H01L 33/20, H01L 33/38

(54) **WAFER HAVING MICRO-LED STRUCTURE, PRODUCTION METHOD FOR WAFER HAVING MICRO-LED STRUCTURE, AND PRODUCTION METHOD FOR JUNCTION-TYPE SEMICONDUCTOR WAFER HAVING MICRO-LED STRUCTURE**

(30) Priority: 12.01.2022 JP 2022003258
(71) Applicant: Shin-Etsu Handotai Co., Ltd., Tokyo 100-0004 (JP)
(72) Inventor: ISHIZAKI, Junya, Annaka-shi, Gunma 379-0196 (JP)
(74) Representative: Mooser, Sebastian Thomas
(86) International application number: PCT/JP2022/045509
(87) International publication number: WO 2023/136003

(57) **Abstract**

The present invention is a wafer having a micro-LED structure, the wafer including a starting substrate, a mask formed on the starting substrate and having a mask pattern including an opening, and a plurality of epitaxial layer structures, each of the plurality of structures selectively grown on a portion corresponding to the opening of the mask pattern on the starting substrate, in which each of the plurality of the epitaxial layer structures has a pyramid-shape or a truncated pyramid-shape surrounded by {111} planes, the plurality of epitaxial layer structures includes a first structure, as a light-emitting device portion, and a second structure connected to the first structure, and a polarity of an electrode of the first structure is different from that of an electrode of the second structure, and the first structure and the second structure constitute a micro-LED structure operable as one micro-LED. Thereby, the wafer having a micro-LED structure, in which generation of brightness decrease is suppressed, can be provided.

## Description

### TECHNICAL FIELD

The present invention relates to a wafer having a micro-LED structure, a method for manufacturing a wafer having a micro-LED structure, and a method for manufacturing a bonded semiconductor wafer having a micro-LED structure.

### BACKGROUND ART

A technique to separate parts necessary to function as light-emitting devices (hereinafter, referred to as functional layers) out of laminates epitaxially grown on starting substrates (hereinafter referred to as epitaxial layer structures) from starting substrates and transfer the parts to another substrate is an important technique to mitigate restriction due to physical properties of the starting substrates and to increase the degree of freedom in designing device systems.

Concerning micro-LED devices, transferring the devices staying on the starting substrates to a drive circuit is difficult, and a transferring technique to transfer functional layers to appropriate substrates is indispensable. To produce a donor substrate capable of performing the transferring to the drive circuit suitable for the micro-LED device, the technique to realize the transferring is necessary in which the functional layer is bonded to a permanent substrate to obtain a bonded substrate and then the starting substrate is removed from this bonded substrate, or the starting substrate is removed while the function layer being held by a temporary support substrate and then the function layer is bonded to the permanent substrate, and the like.

In addition, when the function layer is epitaxially grown on the entire wafer, and an obtained epitaxial layer is device-isolated by etching processing to provide a desired micro-LED size, etching damage is generated at a processed interface, which causes a brightness decrease. In the micro-LED with a small device size, it is problematic that the brightness decrease due to this etching damage is significant.

Patent Document 1 discloses a technique for thermo-compressionally bonding a semiconductor epitaxial substrate to a temporary supporting substrate via a dielectric layer and a technique for separating a temporary supporting substrate and an epitaxial functional layer by wet etching. In addition, Patent Document 2 discloses a technique in which a sacrificial layer and a semiconductor crystal layer are formed on a single crystal layer of a starting substrate in this order, and an isolation groove is formed to the semiconductor crystal layer to expose the sacrificial layer, and then the semiconductor crystal layer is bonded to a transfer substrate, and then sacrificial-layer etching is performed via the isolation groove, thereby separating the starting substrate.

Manufacturing of a micro-LED having a miniaturized light-emitting device portion can be realized using these techniques; however, no improvement measures toward the brightness decrease have not been presented.

### CITATION LIST

### PATENT LITERATURE

Patent Document 1: JP 2021-27301 A
Patent Document 2: WO 2014-020906 A1

### SUMMARY OF INVENTION

### TECHNICAL PROBLEM

The present invention has been made in view of the above-described problem. An object of the present invention is to provide a wafer having a micro-LED structure in which generation of a brightness decrease is suppressed; a method for manufacturing the wafer having a micro-LED structure in which generation of a brightness decrease is suppressed; and a method for manufacturing a bonded semiconductor wafer having a micro-LED structure in which generation of a brightness decrease is suppressed.

### SOLUTION TO PROBLEM

To achieve the object, the present invention provides a wafer having a micro-LED structure, the wafer comprising:
a starting substrate;
a mask formed on the starting substrate and having a mask pattern including an opening; and
a plurality of epitaxial layer structures, each of the plurality of structures selectively grown on a portion corresponding to the opening of the mask pattern on the starting substrate,
wherein each of the plurality of the epitaxial layer structures has a pyramid-shape or a truncated pyramid-shape surrounded by {111} planes,
the plurality of epitaxial layer structures includes a first structure, as a light-emitting device portion, and a second structure connected to the first structure, and
a polarity of an electrode of the first structure is different from that of an electrode of the second structure, and the first structure and the second structure constitute a micro-LED structure operable as one micro-LED.

In the inventive wafer having a micro-LED structure, the micro-LED structure constituted on the wafer is constituted by the first structure and the second structure of the epitaxial layer structures selectively grown in a state separated by the mask in advance; thus, device-isolation processing is not necessary; in addition, since the polarity of the electrode of the first structure is different from that of the electrode of the second structure, one of the electrodes can make contact with an N-type electrode and the other of the electrodes can make contact with a P-type electrode, resulting in eliminating a need for processing such as dry etching of the epitaxial layer structure to form electrodes. Consequently, the inventive wafer having a micro-LED structure can provide the micro-LED structure, in which brightness decrease due to damage originated by the processing such as the device-isolation processing and electrode-forming processing is suppressed. With a transfer of the micro-LED structure from the inventive wafer having a micro-LED structure to a substrate suitable for a micro-LED device, the micro-LED device having the micro-LED structure with excellent brightness can be produced.

It is preferred that the plurality of the epitaxial layer structures have thin films which are full depletion layers in {111} plane directions.

By including such a plurality of epitaxial layer structures, an insulating property between the electrodes can be secured.

It is preferred that the first structure is the light-emitting device portion having an AlGaInP-based light-emitting layer and Lh ≤ 0.707 × Lws where a width of a shortest portion at a bottom is Lws, and a total thickness of the first structure in a direction perpendicular to a surface of the starting substrate is Lh.

In the first structure having such a configuration, all epitaxial layers necessary to function as the light-emitting device portion can be made to grow in accordance with the design thickness in the [001] direction perpendicular to the starting substrate surface.

The width Lws of the shortest portion at the bottom of the first structure may be 10 um or more and 100 um or less.

According to the inventive wafer having a micro-LED structure, even when the micro-LED structure has the width Lws of the shortest portion of the bottom of the first structure with 10 um or more and 100 um or less, the generation of brightness decrease can be sufficiently suppressed.

It is preferred that the epitaxial layer structure includes an active layer, and the second structure is a non-light-emitting device portion and includes a pyramid-shape bridge portion at least partially, and 1.5 um < W < T/0.707 where a width of a shortest part of the bridge portion is W [pm] and a sum of thicknesses of the epitaxial layer structure up to the active layer in the direction perpendicular to the surface of the starting substrate is T [um].

When a lower layer below the active layer is made to be the first conductivity-type and an upper layer is made to be the second conductivity-type, and by satisfying W < T/0.707, a bridge portion of the second structure can be pyramid-shape having no flat portion before reaching the second conductivity-type layer. In addition, when W > 1.5 um, a thickness of a first conductivity-type cladding layer necessary to make contact with a first conductivity-type electrode can be ensured.

In addition, the present invention provides a wafer having a micro-LED structure, the wafer comprising:
a starting substrate; and
a plurality of epitaxial layer structures each of which is selectively grown on a portion of the starting substrate,
wherein each of the plurality of the epitaxial layer structures has a pyramid-shape or a truncated pyramid-shape surrounded by {111} planes,
the plurality of epitaxial layer structures includes a first structure, as a light-emitting device portion, and a second structure connected to the first structure, and
a polarity of an electrode of the first structure is different from that of an electrode of the second structure, and the first structure and the second structure constitute a micro-LED structure operable as one micro-LED.

The wafer having a micro-LED structure according to another aspect of the present invention may not have a mask. In the wafer having a micro-LED structure according to this aspect, since the micro-LED structure constituted on the wafer is constituted by the first structure and the second structure of epitaxial layer structures, each of which is selectively grown, device-isolation processing is not necessary. In addition, the polarity of the electrode of the first structure is different from that of the electrode of the second structure. Thus, one of the electrodes can make contact with an N-type electrode and the other of the electrodes can make contact with a P-type electrode, resulting in eliminating a need for processing, such as dry etching, to the epitaxial layer structure to form the electrodes. Consequently, the wafer having a micro-LED structure according to this aspect can provide the micro-LED structure, in which brightness decrease due to damage originated by the processing such as the device-isolation processing and the electrode-forming processing is suppressed. By a transfer of the micro-LED structure from the wafer having a micro-LED structure according to such an aspect to a substrate suitable for the micro-LED device, the micro-LED device can be produced in which the micro-LED structure that shows excellent brightness is provided.

Moreover, the present invention provides a method for manufacturing a wafer having a micro-LED structure, the method comprising:
providing a starting substrate;
forming a mask having a mask pattern including an opening on the starting substrate;
selectively growing a plurality of epitaxial layer structures, including a first structure as a light-emitting device portion and a second structure connected to the first structure, on a portion exposed through the opening of the mask pattern on the starting substrate, such that each of the plurality of the epitaxial layer structures has a pyramid-shape or a truncated pyramid-shape surrounded by {111} planes; and
forming electrodes of different polarities to the first structure and the second structure, respectively, to manufacture a wafer having a micro-LED structure including the first structure and the second structure and operable as one micro-LED.

The wafer having a micro-LED structure manufactured by such a manufacturing method has the micro-LED structure constituted by the first structure and the second structure of the epitaxial layer structures selectively grown in a state separated by the mask in advance. Such a micro-LED structure has no need for device-isolation processing. In addition, since the polarity of the electrode of the first structure is different from that of the electrode of the second structure, one of the electrode can make contact with an N-type electrode and the other of the electrodes can make contact with a P-type electrode, resulting in eliminating a need for processing to form the electrodes. Consequently, according to the inventive method for manufacturing the wafer having a micro-LED structure, the wafer having a micro-LED structure can be manufactured, in which brightness decrease due to damage originated by the processing such as the device-isolation processing and the electrode-forming processing is suppressed.

Furthermore, the present invention provides a method for manufacturing a bonded semiconductor wafer having a micro-LED structure, the method comprising:
manufacturing a wafer having a micro-LED structure by the inventive method for manufacturing the wafer having a micro-LED structure;
bonding a surface of the wafer where the micro-LED structure is formed to one of main surfaces of a support substrate via a bonding material to obtain a bonded substrate; and
removing the starting substrate from the bonded substrate to manufacture a bonded semiconductor wafer having the micro-LED structure.

According to the inventive method for manufacturing the bonded semiconductor wafer having a micro-LED structure, the wafer having a micro-LED structure is manufactured in accordance with the inventive method for manufacturing the inventive wafer having a micro-LED structure and used for manufacturing the bonded semiconductor wafer. Thus, the bonded semiconductor wafer can be manufactured, the bonded semiconductor wafer having a micro-LED structure, in which brightness decrease due to damage originated by the processing such as the device-isolation processing and the electrode-forming processing is suppressed.

### ADVANTAGEOUS EFFECTS OF INVENTION

As described above, according to the inventive wafer having a micro-LED structure, it is possible to have the micro-LED structure, in which brightness decrease due to damage originated by the processing such as the device-isolation processing and the electrode-forming processing is suppressed. In addition, with a transfer of the micro-LED structure from the inventive wafer having a micro-LED structure to a substrate suitable for a micro-LED device, the micro-LED device having the micro-LED structure that exhibits excellent brightness can be produced.

In addition, according to the inventive method for manufacturing the wafer having a micro-LED structure, the wafer having a micro-LED structure, in which brightness decrease due to damage originated by the processing such as the device-isolation processing and the electrode-forming processing is suppressed, can be manufactured.

Moreover, according to the inventive method for manufacturing the bonded semiconductor wafer having a micro-LED structure, the bonded semiconductor wafer having a micro-LED structure, in which brightness decrease due to damage originated by the processing such as the device-isolation processing and the electrode-forming processing is suppressed, can be manufactured.

### BRIEF DESCRIPTION OF DRAWINGS

FIG. 1 is a schematic plane view illustrating an example of a wafer having a micro-LED structure according to the present invention.
FIG. 2 is a projection view illustrating of the wafer having the micro-LED structure shown in FIG. 1 from II direction.
FIG. 3 is a schematic plane view illustrating another example of the wafer having a micro-LED structure according to the present invention.
FIG. 4 is a projection view illustrating the wafer having the micro-LED structure shown in FIG. 3 from IV direction.
FIG. 5 is a schematic plane view illustrating another example of the wafer having a micro-LED structure according to the present invention.
FIG. 6 is a projection view illustrating the wafer having the micro-LED structure shown in FIG. 5 from a VI direction.
FIG. 7 is a schematic plane view illustrating another example of the wafer having a micro-LED structure according to the present invention.
FIG. 8 is a projection view illustrating the wafer having the micro-LED structure shown in FIG. 7 from VIII direction.
FIG. 9 is a schematic plane view illustrating another example of the wafer having a micro-LED structure according to the present invention.
FIG. 10 is a projection view illustrating the wafer having the micro-LED structure shown in FIG. 9 from X direction.
FIG. 11 is a schematic plane view illustrating another example of the wafer having a micro-LED structure according to the present invention.
FIG. 12 is a schematic plane view illustrating a step in an example of a method for manufacturing the wafer having the micro-LED structure according to the present invention.
FIG. 13 is a schematic cross-sectional view along line XIII-XIII' of the structure shown in FIG. 12.
FIG. 14 is a schematic plane view illustrating a step in an example of the method for manufacturing the wafer having a micro-LED structure according to the present invention.
FIG. 15 is a schematic cross-sectional view along line XV-XV' of the structure shown in FIG. 14.
FIG. 16 is a schematic cross-sectional view along line XVI-XVI' of the structure shown in FIG. 14.
FIG. 17 is a projection view from XVII direction of the structure shown in FIG. 14.
FIG. 18 is an enlarged view of XVIII portion of the structure shown in FIG. 15.
FIG. 19 is an enlarged view of XIX portion of the structure shown in FIG. 16.
FIG. 20 is a schematic view illustrating a step in an example of a method for manufacturing a bonded semiconductor wafer having a micro-LED structure according to the present invention.
FIG. 21 is a schematic view illustrating a step in an example of the method for manufacturing the bonded semiconductor wafer having a micro-LED structure according to the present invention.
FIG. 22 is a schematic view illustrating a step in an example of the method for manufacturing the bonded semiconductor wafer having a micro-LED structure according to the present invention.
FIG. 23 is a schematic view illustrating a step in an example of the method for manufacturing the bonded semiconductor wafer having a micro-LED structure according to the present invention.
FIG. 24 is a schematic view illustrating a step in an example of the method for manufacturing the bonded semiconductor wafer having a micro-LED structure according to the present invention.
FIG. 25 is a schematic view illustrating a step in an example of the method for manufacturing the bonded semiconductor wafer having a micro-LED structure according to the present invention.
FIG. 26 is a schematic view illustrating a step in an example of the method for manufacturing the bonded semiconductor wafer having a micro-LED structure according to the present invention.
FIG. 27 is a schematic view illustrating the bonded semiconductor wafer manufactured by an example of the method for manufacturing the bonded semiconductor wafer having a micro-LED structure according to the present invention.
FIG. 28 is a schematic cross-sectional view illustrating a step in an example of a method for manufacturing a bonded semiconductor wafer in Comparative Example.
FIG. 29 is a schematic cross-sectional view illustrating a step in an example of the method for manufacturing the bonded semiconductor wafer in Comparative Example.
FIG. 30 is a schematic cross-sectional view illustrating a step in an example of the method for manufacturing the bonded semiconductor wafer in Comparative Example.
FIG. 31 is a schematic cross-sectional view illustrating a step in an example of the method for manufacturing the bonded semiconductor wafer in Comparative Example.
FIG. 32 is a schematic cross-sectional view illustrating a step in an example of the method for manufacturing the bonded semiconductor wafer in Comparative Example.
FIG. 33 is a schematic cross-sectional view illustrating a step in an example of the method for manufacturing the bonded semiconductor wafer in Comparative Example.
FIG. 34 is a schematic cross-sectional view illustrating a step in an example of the method for manufacturing the bonded semiconductor wafer in Comparative Example.
FIG. 35 is a schematic cross-sectional view illustrating a step in an example of the method for manufacturing the bonded semiconductor wafer in Comparative Example.
FIG. 36 is a graph illustrating a relation between a dice design size and luminous efficiency of micro-LEDs produced in each of Example and Comparative Example.

### DESCRIPTION OF EMBODIMENTS

As described above, development has been required with regard to a wafer having a micro-LED structure in which generation of a brightness decrease is suppressed; a method for manufacturing the wafer having a micro-LED structure in which generation of a brightness decrease is suppressed; and a method for manufacturing a bonded semiconductor wafer having a micro-LED structure in which generation of a brightness decrease is suppressed.

The present inventor focuses on the fact that while an epitaxial layer structure, which is to be a micro-LED structure, is epitaxially grown to an opening of a mask pattern provided on a starting substrate, by making a V/III ratio of raw materials to 1 or more and 50 or less, {111} planes with slow growth speed appear along with a growth of a (001) plane parallel to a surface of a starting substrate, resulting in the epitaxial layer structure capable of forming pyramid-shape or truncated pyramid-shape. In addition, the present inventor focuses on the fact that a thickness of the layer of a slope becomes significantly thin compared with a thickness in a direction perpendicular to the surface of the substrate (hereinafter, [001] direction) in such a shapes and thus full depletion of unneeded layers is possible by adjusting a size of the opening and the V/III ratio of the raw materials. The present inventor has earnestly studied on such steps and found that a pair of the epitaxial layer structures in the pyramid-shape or the truncated pyramid-shape, each selectively grown, can be used as the micro-LED structure without processing for device-separation or electrode formation. This finding has led to the completion of the present invention.

That is, the present invention is a wafer having a micro-LED structure, the wafer comprising:
a starting substrate;
a mask formed on the starting substrate and having a mask pattern including an opening; and
a plurality of epitaxial layer structures, each of the plurality of structures selectively grown on a portion corresponding to the opening of the mask pattern on the starting substrate,
wherein each of the plurality of the epitaxial layer structures has a pyramid-shape or a truncated pyramid-shape surrounded by {111} planes,
the plurality of epitaxial layer structures includes a first structure, as a light-emitting device portion, and a second structure connected to the first structure, and
a polarity of an electrode of the first structure is different from that of an electrode of the second structure, and the first structure and the second structure constitute a micro-LED structure operable as one micro-LED.

In addition, the present invention is a wafer having a micro-LED structure, the wafer comprising:
a starting substrate; and
a plurality of epitaxial layer structures each of which selectively grown on a portion of the starting substrate,
wherein each of the plurality of the epitaxial layer structures has a pyramid-shape or a truncated pyramid-shape surrounded by {111} planes,
the plurality of epitaxial layer structures includes a first structure, as a light-emitting device portion, and a second structure connected to the first structure, and
a polarity of an electrode of the first structure is different from that of an electrode of the second structure, and the first structure and the second structure constitute a micro-LED structure operable as one micro-LED.

Moreover, the present invention is a method for manufacturing a wafer having a micro-LED structure, the method comprising:
providing a starting substrate;
forming a mask having a mask pattern including an opening on the starting substrate;
selectively growing a plurality of epitaxial layer structures, including a first structure as a light-emitting device portion and a second structure connected to the first structure, on a portion exposed through the opening of the mask pattern on the starting substrate, such that each of the plurality of the epitaxial layer structures has a pyramid-shape or a truncated pyramid-shape surrounded by {111} planes; and
forming electrodes of different polarities to the first structure and the second structure, respectively, to manufacture a wafer having a micro-LED structure including the first structure and the second structure and operable as one micro-LED.

Furthermore, the present invention is a method for manufacturing a bonded semiconductor wafer having a micro-LED structure, the method comprising:
manufacturing a wafer having a micro-LED structure by the inventive method for manufacturing the wafer having a micro-LED structure;
bonding a surface of the wafer where the micro-LED structure is formed to one of main surfaces of a support substrate via a bonding material to obtain a bonded substrate; and
removing the starting substrate from the bonded substrate to manufacture a bonded semiconductor wafer having the micro-LED structure.

Hereinafter, the present invention will be described in detail with reference to the drawings. However, the present invention is not limited thereto.

### [Wafer having Micro-LED Structure]

### (First Embodiment)

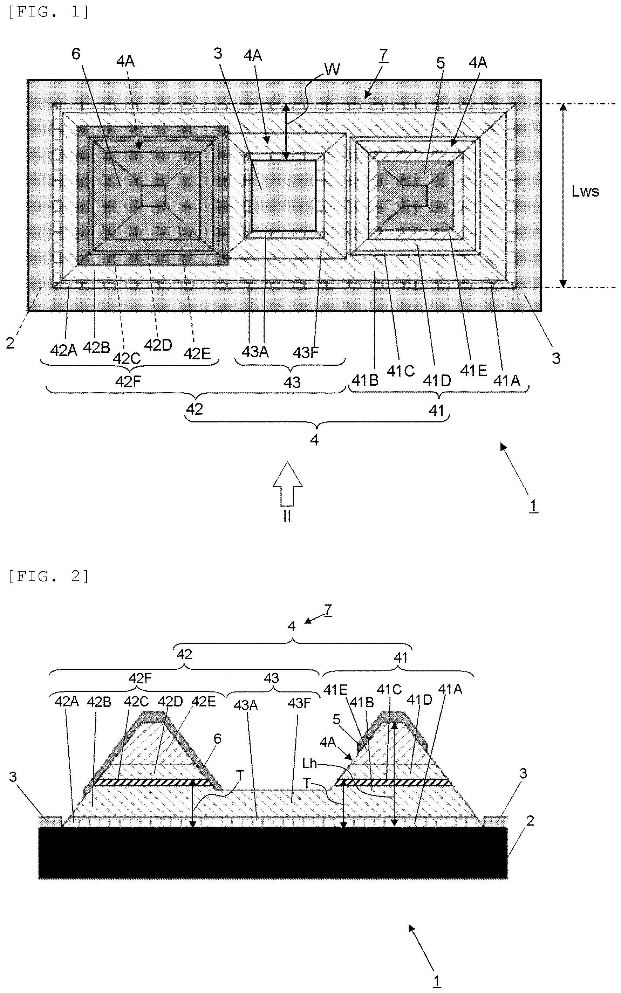

The first embodiment of the inventive wafer having a micro-LED structure is schematically shown in FIGs. 1 and 2. FIG. 1 is a plane view, and FIG. 2 is a projection view (side view) of FIG. 1 from a II direction.

The wafer 1 having a micro-LED structure shown in FIGs. 1 and 2 includes a starting substrate 2, a mask 3 formed on this starting substrate 2 with a mask pattern including an opening (not shown in FIG. 1 and FIG. 2), and a plurality of epitaxial layer structures 4 each of which selectively grown on a portion corresponding to the opening of the mask pattern on the starting substrate 2 (not shown in FIGs. 1 and 2).

Each of the plurality of the epitaxial layer structures 4 has a pyramid-shape or a truncated pyramid-shape surrounded by {111} planes 4A.

The plurality of the epitaxial layer structures 4 includes a first structure 41, as a light-emitting device portion, and a second structure 42 connected to the first structure 41.

The first structure 41 includes an electrode 5. The second structure 42 includes an electrode 6. The electrodes 5 and 6 are of different polarities from each other. The first structure 41 and the second structure 42 constitute a micro-LED structure 7 operable as one micro-LED.

In the wafer 1 having such a micro-LED structure 7, the micro-LED structure 7 constituted on the wafer 1 is constituted by the first structure 41 and the second structure 42 of the epitaxial layer structures 4 each of which selectively grown in a state separated by the mask 3 in advance; thus, device-isolation processing is not necessary. In addition, since the polarity of the electrode 5 of the first structure 41 is different from that of the electrode 6 of the second structure 42, and one of the electrodes can make contact with an N-type electrode and the other of the electrodes can make contact with a P-type electrode, resulting in eliminating a need for processing such as dry etching of the epitaxial layer structure to form electrodes. Consequently, the wafer 1 having a micro-LED structure 7 shown in FIGs. 1 and 2 can provide the micro-LED structure 7, in which brightness decrease due to damage originated by the processing such as the device-isolation processing and an electrode-forming processing is suppressed. In addition, with a transfer of the micro-LED structure 7 from the wafer 1 having such a micro-LED structure 7 to a substrate suitable for a micro-LED device, the micro-LED device can be produced in which the micro-LED structure 7 that shows excellent brightness is provided.

Hereinafter, the wafer 1 having a micro-LED structure 7 of the first embodiments shown in FIGs. 1 and 2 is described in more detail.

As the starting substrate 2, for example, a first conductivity-type GaAs substrate can be used without limitation. The starting substrate 2 may have a buffer layer (not shown), for example, a first conductivity-type GaAs buffer layer on a surface thereof. In the first embodiment shown in FIGs. 1 and 2, the GaAs buffer layer typically has a thickness of 0.5 µm.

The mask 3 forms, for example, a nonpolar dielectric film such as SiO₂ or silicon nitride, and forms the mask pattern made of the nonpolar dielectric film having the openings. Of the openings of the mask pattern, a region where the first structure 41 is formed has, for example, a rectangular planar shape. In addition, of the openings of the mask pattern, a region where the second structure 42 is formed is, for example, the region having all corners of right angles (90°). The openings of the mask pattern, the region in which the first structure 41 is formed and the region in which the second structure 42 is formed are described in a description of the inventive method for manufacturing the wafer having a micro-LED structure in a later section with reference to the drawings.

In the first embodiment shown in FIGs. 1 and 2, the mask 3 includes a portion formed on a portion including a center of the starting substrate 2 and a portion formed on an outer edge portion of the substrate 2.

The first structure 41 is the light-emitting device portion having the truncated pyramid-shape (also referred to as a pyramidal shape), in which a sacrificial layer 41A, a first cladding layer 41B, an active layer 41C, a second cladding layer 41D, an intermediate layer (not shown), and a window layer 41E are included in this order. Because the first structure 41 is a part of the epitaxial layer structure 4, these layers are the epitaxial layers.

The sacrificial layer 41A can include, for example, an AlAs sacrificial layer, a GaInP sacrificial layer, and/or a GaAs sacrificial layer. The sacrificial layer 41A may be constituted by a plurality of layers. In the first embodiment shown in FIGs. 1 and 2, the sacrificial layer 41A is a first conductivity-type AlAs sacrificial layer having a thickness of 0.5 µm.

The first cladding layer 41B is, for example, a first conductivity-type AlGaInP (for example, (Al_{y}Ga_{1-y})ₓIn₁₋ₓP (0.4 ≤ x ≤ 0.6, 0 < y ≤ 1)) first cladding layer. In the first embodiment shown in FIGs. 1 and 2, the first cladding layer 41B is the layer having "x" and "y" in the general formula as 0.5 and 0.85, respectively, and a thickness of 1.0 µm.

The active layer 41C is, for example, a non-doped AlGaInP (for example, (Al_{y}Ga_{1-y})ₓIn₁₋ₓP (0.4 ≤ x ≤ 0.6, 0 ≤ y ≤ 0.6))-based light emitting layer. In the first embodiment shown in FIGs. 1 and 2, the active layer 41C is the layer having "x" and "y" in the general formula above as 0.5 and 0.1, respectively, and having a thickness of 0.25 µm.

The second cladding layer 41D is, for example, a second conductivity-type AlGaInP (for example, (Al_{y}Ga_{1-y})ₓIn₁₋ₓP (0.4 ≤ x ≤ 0.6, 0 < y ≤ 1)) second cladding layer. In the first embodiment shown in FIGs. 1 and 2, the second cladding layer 41D is the layer having "x" and "y" in the general formula above as 0.5 and 0.85, respectively, and a thickness of 0.75um.

The intermediate layer not shown is, for example, a second conductivity-type GaInP intermediate layer, and is the layer having a thickness of 0.1 um in the first embodiment shown in FIGs. 1 and 2.

The window layer 41E is, for example, a second conductivity-type GaP window layer. In the first embodiment shown in FIGs. 1 and 2, the window layer 41E is the layer having a thickness of 1.9 µm.

As shown in FIG. 1, a width of a shortest portion at a bottom of the first structure 41 is Lws. Even when the width Lws of the shortest portion at the bottom of the first structure 41, as the light-emitting device portion, is 10 um or more and 100 um or less, i.e., a typical micro-LED size, the inventive wafer 1 having a micro-LED structure 7 can provide the micro-LED structure 7 in which brightness decrease due to damage originated by the processing is suppressed because the processing such as the device-isolation processing and electrode-forming processing is unnecessary.

In addition, as shown in FIG. 2, a total thickness of the first structure 41 in a direction perpendicular to a surface of the starting substrate 2 ([001] direction) is Lh. It is preferred that the total thickness Lh of the first structure 41 and the width Lws of the shortest portion at the bottom of the first structure 41 satisfy Lh ≤ 0.707 × Lws. The first structure 41 having such a structure can be prevented from being a pyramid-shape with no flat portion on an apex before reaching a design thickness, thereby all epitaxial layers necessary to function as the light-emitting device portion can be made to grow in the [001] direction to the design thickness. The lower limit of the total thickness Lh is not particularly limited but is, for example, 0.5 µm.

As shown in FIGS. 1 and 2, the second structure 42 is connected to the first structure 41. More specifically, the second structure 42 includes a pyramid-shaped bridge portion 43 at least partially, which is in contact with the first structure 41.

The bridge portion 43 has a sacrificial layer 43A integrated with the sacrificial layer 41A of the first structure 41, and a stacked portion 43F on the layer 43A.

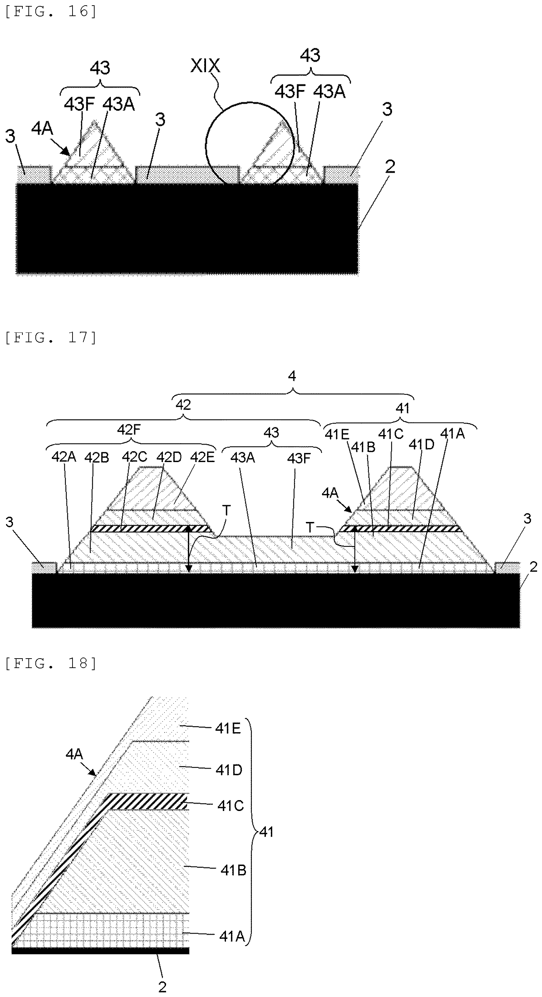

As shown in FIG. 18 described later, the stacked portion 43F contains respective materials of the epitaxial layers of the first structure 41 but has the pyramid-shape so as to make the apex at a top layer of the first cladding layer. Consequently, only the {111} planes 4A are grown above the active layer, resulting in thin films. That is, the bridge portion 43 has a second conductivity-type layer being fully depleted, thus practically behaving as a first conductivity-type.

The second structure 42 shown in FIGs. 1 and 2 further includes a sacrificial layer 42A, a first cladding layer 42B, an active layer 42C, a second cladding layer 42D, an intermediate layer (not shown), and a window layer 42E in this order as similar to the first structure 41, and these layers constitute a stacked portion 42F. The sacrificial layer 42A is integrated with the sacrificial layers 41A and 43A.

The second structure 42 shown in FIGs. 1 and 2 is a non-light-emitting device portion. In addition, as shown in FIG. 1, a width of a shortest part of the bridge portion 43 is W [pm]. Moreover, a sum of thicknesses of the epitaxial layer structure 4 up to the active layers 41C and 42C in the direction ([001] direction) perpendicular to the surface of the starting substrate 2 is T [pm]. In the first embodiment shown in FIGs. 1 and 2, then 1.5 um < W < T/0.707. When layers below the active layer are in the first conductivity-type and layers above the active layer are in the second conductivity-type, by satisfying W < T/0.707, a bridge portion 43 of the second structure 42 can have a pyramid-shape having no flat portion before reaching the second conductivity-type layers. In addition, when W > 1.5 um, a thickness of a first conductivity-type cladding layer necessary to contact a first conductivity-type electrode can be ensured.

It is preferred that a plurality of the epitaxial layer structures 4 (in the first embodiment shown in FIGs. 1 and 2, the first structure 41, and the second structure 42 including the stacked portion 42F and the bridge portion 43) have thin films which are full depletion layers in {111} plane 4A directions.

On the window layer 41E portion of the first structure 41, the electrode 5 is formed with a material that allows a formation of an ohmic to a second conductivity-type semiconductor.

On the other hand, on the stacked portion 42F of the second structure 42, the electrode 6 is formed with a material that allows a formation of an ohmic to a first conductivity-type semiconductor.

In the first embodiment shown in FIGs. 1 and 2, the electrode 6 formed on the second structure 42 extends from the window layer 42E, which is the structural apex of the stacked portion 42F, to the bridge portion 43 and is in ohmic contact with the first conductivity-type bridge portion 43. In this case, a part of the electrode 6 is in contact with the second cladding layer 42D and the window layer 42E of the second structure 42, which is a non-light-emitting device portion, either directly or through the depletion layer; however, another part of the electrode 6 is in contact with the first conductivity-type bridge portion 43, thus being short-circuited state and not conducting current through a PiN junction, resulting in no electrical problem.

Since the bridge portion 43, a part of the plurality of the epitaxial layer structures 4, has thin films which are full depletion layers in {111} plane 4A directions, an insulating property between the electrodes 5 and 6 can be secured as described above.

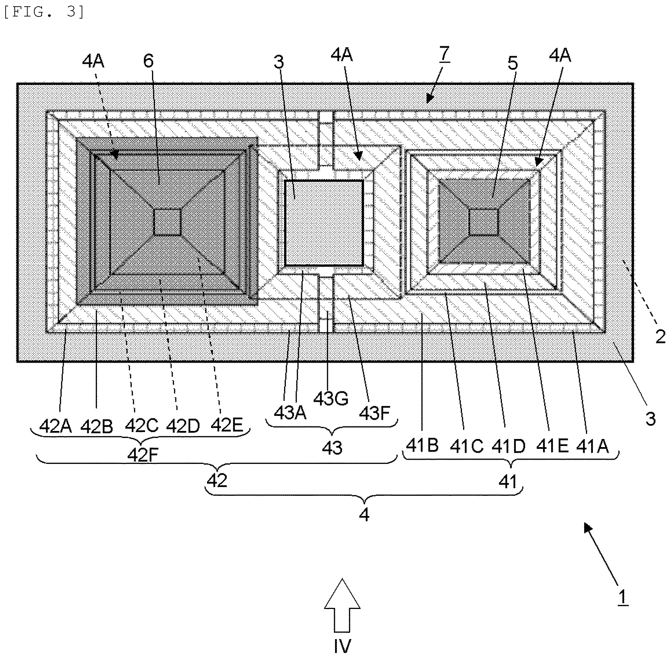

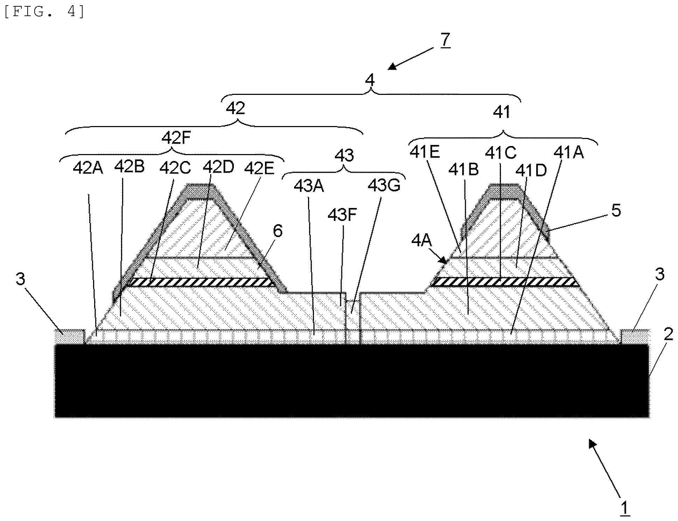

Moreover, an outermost periphery of the bridge portion 43 is covered with fully depleted ultrathin layers, and thus the insulating property between the electrodes is secured; however, when the effective V/III ratio on the surface increases due to a lower growth temperature in the formation process of the bridge portion 43, etc., the layer thickness on the slope may become large, resulting in leakage. In such a case, as in a variant shown in FIGs. 3 and 4 (FIG. 3: a plane view; FIG. 4: a projection view of FIG. 3 from a IV direction (side view)), a part of the stacked portion 43F of the bridge portion 43 may be removed by a method such as dry etching for making a stacked portion 43G to prevent the leakage.

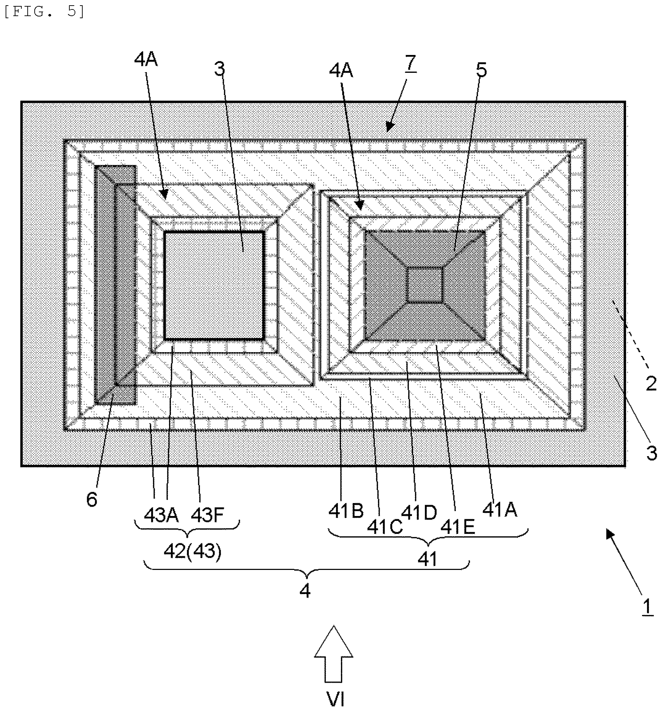

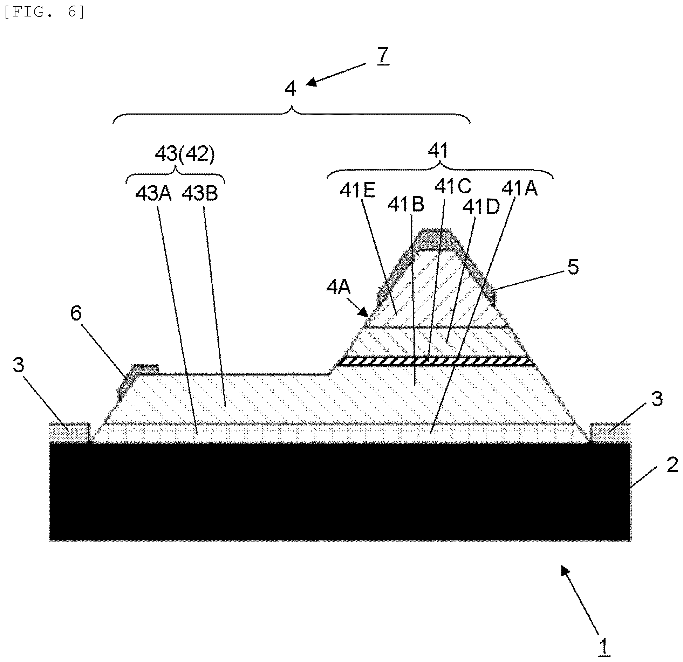

In addition, in the first embodiment described above, a case is shown in which the height of the first structure 41, which is the light-emitting device portion, and the height of the stacked portion 42F of the second structure 42, which is the non-light-emitting device portion, are even; however, the stacked portion 42F of the second structure 42, which is the non-light-emitting device portion, may be lower than the first structure 41, which is the light-emitting device portion. Moreover, as in a variant shown in FIGs. 5 and 6, the second structure 42, as the non-light-emitting device portion, may only have the bridge portion 43 (FIG. 5: a plane view; FIG. 6: a projection view of FIG. 5 from a VI direction (side view)). Such a design change can be made simply by changing the size and design of the mask pattern of the mask 3. On the other hand, the stacked portion 42F of the second structure 42, which is the non-light-emitting device portion, can be made higher than the first structure 41, which is the light-emitting device portion; however, the portion 42F usually stops growth thereof when the GaP window layer 41E of the light-emitting device portion is stacked until design thickness, thus the non-light-emitting device portion is never higher than the light-emitting device portion, and the non-light-emitting device portion having a large height than that of the light-emitting device portion has no functional merit. Owing to these reasons, it is suitable that the height of the stacked portion 42F of the second structure 42, as the non-light-emitting device portion, is lower or equal to the height of the first structure 41, as the light-emitting device portion.

### (Second Embodiment)

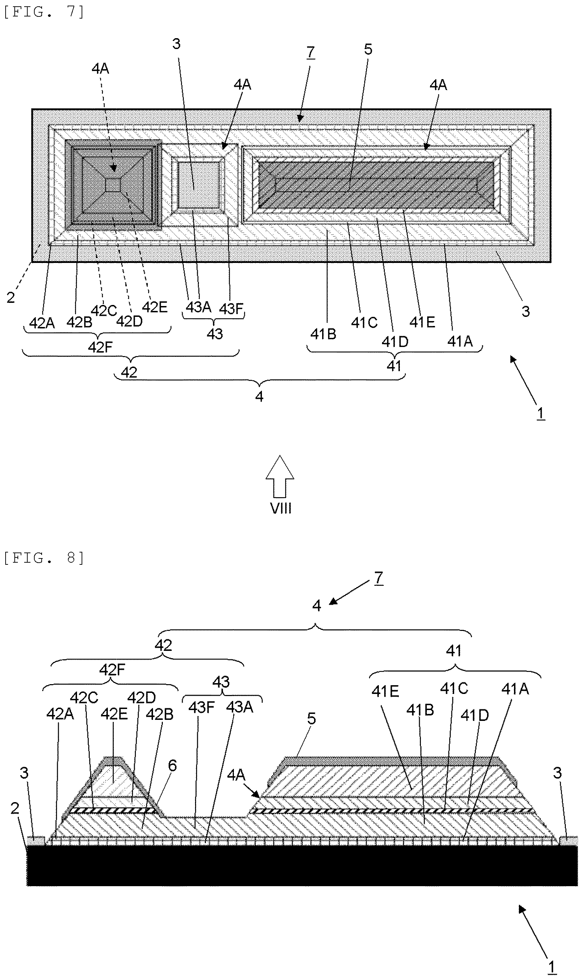

The second embodiment of the inventive wafer having a micro-LED structure is schematically shown in FIGs. 7 and 8. FIG. 7 is a plane view, and FIG. 8 is a projection view (side view) of FIG. 7 from a VIII direction.

The second embodiment shown in FIGs. 7 and 8 is the same as the first embodiment except that a shape of a first structure 41, as a light-emitting device portion, is changed. A rectangular-shaped device can be realized by making a size of the first structure 41, as the light-emitting device portion, horizontally long while keeping a size of a second structure 42, as a non-light-emitting device portion, intact.

### (Third Embodiment)

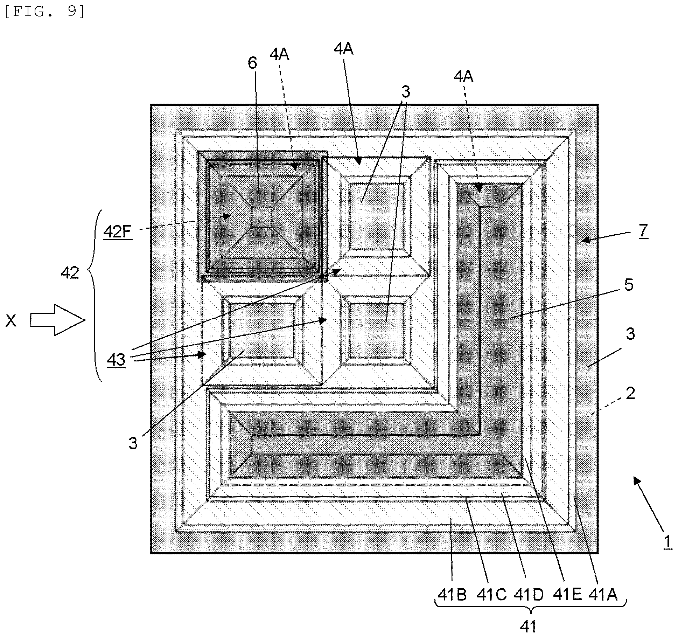

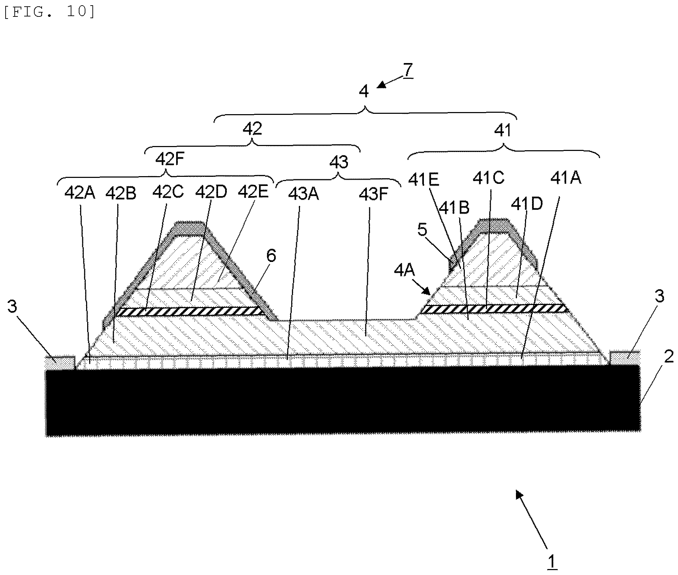

The second embodiment of the inventive wafer having a micro-LED structure is schematically shown in FIGs. 9 and 10. FIG. 9 is a plane view, and FIG. 10 is a projection view (side view) of FIG. 9 from an X direction.

The third embodiment shown in FIGs. 9 and 10 is the same as the first embodiment except that a shape of a first structure 41, as a light-emitting device portion, is changed, and, in line with this, a shape of a bridge portion 43 of a second structure 42, which is a non-light-emitting device portion, is changed. By keeping a size of a stacked portion 42F of the second structure 42, which is the non-light-emitting device portion, intact, and arranging the bridge portion 43 and the first structure 41, which is the light-emitting device portion, along two sides of a periphery of the stacked portion 42F, a device having a shape shown in FIGs. 9 and 10 is realized.

### (Fourth Embodiment)

A wafer having a micro-LED structure according to another aspect of the present invention may not include a mask.

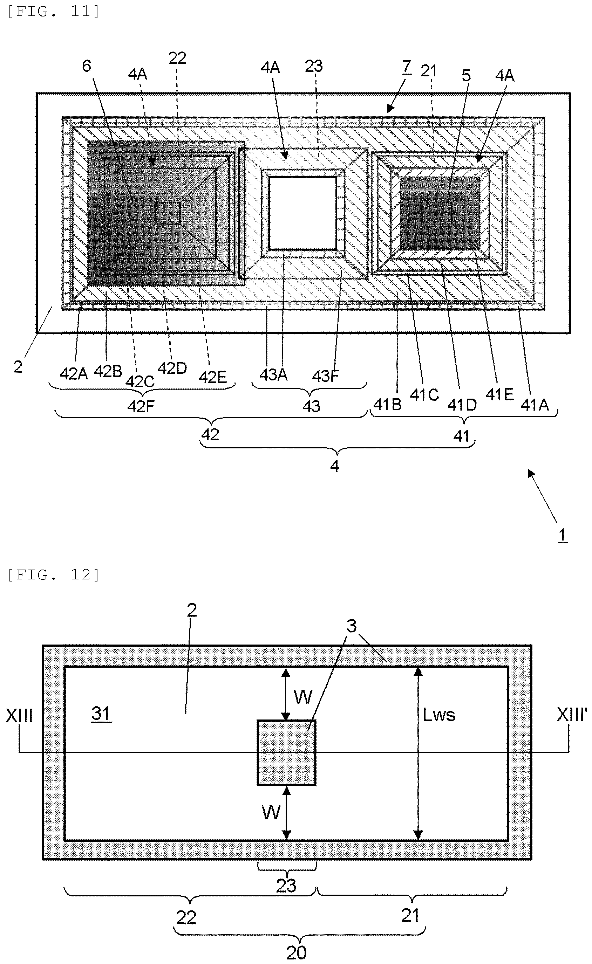

The fourth embodiment of the inventive wafer having a micro-LED structure is schematically shown in FIG. 11. FIG. 11 is a plane view.

The fourth embodiment shown in FIG. 11 is the same as the first embodiment, except that a mask is not included.

More in detail, a wafer 1 having a micro-LED structure shown in FIG. 11 includes a starting substrate 2 and a plurality of epitaxial layer structures 4 selectively grown on portions 21, 22, and 23 of a starting substrate 1. Each of the plurality of epitaxial layer structures 4 is of a pyramid-shape or a truncated pyramid-shape surrounded by {111} planes 4A. The plurality of the epitaxial layer structures 4 includes a first structure 41, as a light-emitting device portion, and a second structure 42 connected to the first structure 41. The first structure 41 has an electrode 5 and the second structure 42 has an electrode 6 having different polarity from that of the electrode 5. The first structure 41 and the second structure 42 constitute a micro-LED structure 7 operable as one micro-LED.

With respect to other matters, description of the first embodiment should be referred.

Such a wafer 1 having the micro-LED structure 7 does not have the mask, but the micro-LED structure 7 constructed on the wafer 1 is constituted by the first structure 41 and the second structure 42 of the epitaxial layer structures 4 each of which has been selectively grown; thus, device-isolation processing is not necessary; in addition, the polarity of the electrode 5 of the first structure 41 is different from that of the electrode 6 of the second structure 42, and thus one of the electrodes can make contact with an N-type electrode and the other of the electrodes can make contact with a P-type electrode, resulting in eliminating a need for processing such as dry etching of the epitaxial layer structure to form electrodes. Consequently, the wafer 1 having the micro-LED structure 7 shown in FIG. 11 can provide the micro-LED structure 7 in which brightness decrease due to damage originated by the processing such as the device-isolation processing and electrode-forming processing is suppressed. With a transfer of the micro-LED structure 7 from the wafer 1 having such a micro-LED structure 7 to a substrate suitable for a micro-LED device, the micro-LED device can be produced in which the micro-LED structure 7 that shows excellent brightness is provided.

### [Method for Manufacturing Wafer having micro-LED Structure]

Hereinafter, as an example of an inventive method for manufacturing a wafer having a micro-LED structure, the method for manufacturing the wafer having a micro-LED structure shown in FIGs. 1 and 2 is described referring to FIGs. 12 to 19.

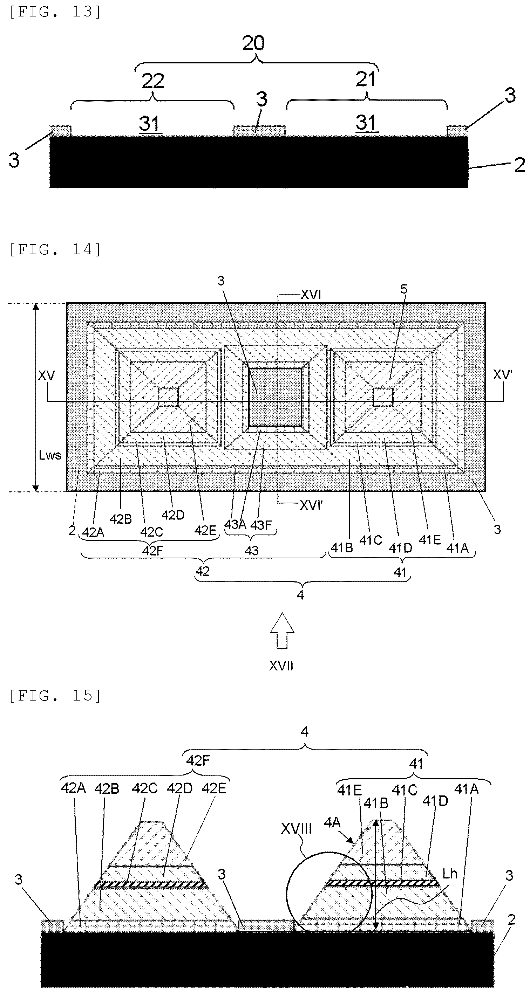

First, a starting substrate 2 shown in FIG. 12 (plane view) and FIG. 13 (cross-sectional view along line XIII-XIII' in FIG. 12), for example, a first conductivity-type GaAs starting substrate, is provided. Next, as shown in FIGs. 12 and 13, a mask 3 having a mask pattern that includes an opening 31 is formed on the starting substrate 2. The mask 3 may be, for example, a nonpolar dielectric film such as SiO₂ or silicon nitride. In the example shown in FIGs. 12 and 13, the mask 3 is formed so as to include a portion formed on the portion including the center of a region of the starting substrate 2 on which the micro-LED structure is to be formed and a portion on the periphery of the starting substrate 2. In this manner, a patterned substrate 2 having a portion 20 exposed through the opening 31.

In this embodiment, as shown in FIGs. 1 and 2, an example is shown, in which a second structure 42, as a non-light-emitting device portion, is laminated with a stacked portion 42F which is a same size as the first structure 41, as the light-emitting device portion, and the first structure 41 is connected the stacked portion 42F via a bridge portion 43. Moreover, in the portion 20 exposed through the opening 31, a region 21 in which the first structure 41 is to be formed has a rectangular planar shape, and a region 22 in which the second structure 42 is formed has a region having all corners of right angles (90°), and each of sides of the opening 31 is arranged almost parallel or almost perpendicular to the [100] direction. When the direction of the sides deviates a few degrees, steps may be generated on the slopes; however, the steps do not grow to a problematic dimension in the size of a micro-LED level.

In the portion 20 exposed through the opening 31, the region 21 in which the first structure 41, as the light-emitting device portion, is to be formed, is arranged as Lh ≤ 0.707 × Lws, where the width of the shortest portion is defined as Lws and a total thickness of an epitaxial layer grown in [001] direction (in a direction perpendicular to a surface of the starting substrate 2) is defined as Lh (FIG. 2). By arranging as Lh ≤ 0.707 × Lws, all epitaxial layers described later can be grown in the [001] direction in accordance with a design thickness. This is because all epitaxial layers necessary to function as the light-emitting device portion can be grown in accordance with design thickness in the [001] direction while preventing becoming a pyramid-shape with no flat portion on an apex before reaching a design thickness and unimpeded by the {111} plane.

On the other hand, in the portion 20 exposed through an opening 31, the region 23 in which the bridge portion 43 is to be formed is arranged as 1.5 um < W < T/0.707 where a width of the region 23 is defined as W [pm], and a sum of thicknesses of the epitaxial layer structure 4 up to an active layer 41C and an active layer 42C to be grown in the [001] direction is defined as T [pm]. When a layer below the active layer is the first conductivity-type and an upper layer is the second conductivity-type, by satisfying W < T/0.707, the bridge portion 43 of the second structure 42 can be shaped in the pyramid-shape with no flat portion before reaching the second conductivity-type layer. In addition, when W > 1.5 um, a thickness of a first conductivity-type cladding layer necessary to contact a first conductivity-type electrode can be ensured.

Next, as shown in FIGs. 14 to 19, a plurality of epitaxial layer structures 4 including the first structure 41, as a light-emitting device portion, and the second structure 42 connected to this first structure 41 are selectively grown on the portion 20 exposed through the opening 31 of the patterned substrate 2 produced as described above.

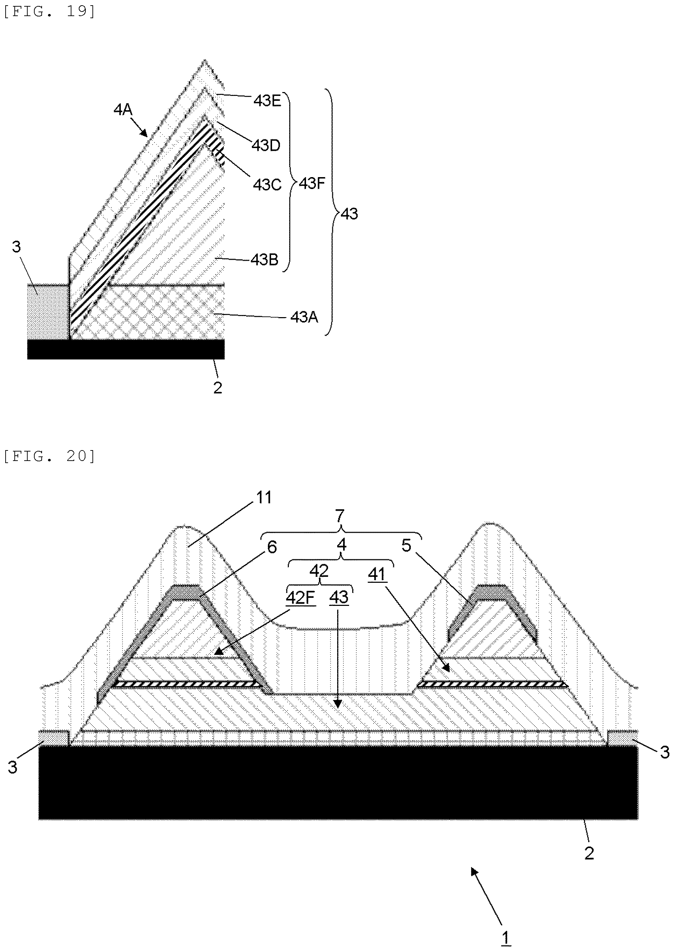

FIG. 14 is a plane view. FIG. 15 is a schematic cross-sectional view along line XV-XV' of the structure shown in FIG. 14. FIG. 16 is a schematic cross-sectional view along line XVI-XVI' of the structure shown in FIG. 14. FIG. 17 is a projection view from XVII direction of the structure shown in FIG. 14. FIG. 18 is an enlarged view of XVIII portion of the structure shown in FIG. 15. FIG. 19 is an enlarged view of XIX portion of the structure shown in FIG. 16.

On the region 21 for forming the first structure 41 in the exposed portion 20 of the pattern substrate 2, a first conductivity-type GaAs buffer layer (not shown) is laminated, then an AlAs sacrificial layer 41A, a first conductivity-type AlGaInP first cladding layer 41B, a non-doped AlGaInP active layer 41C, a second conductivity-type AlGaInP second cladding layer 41D, a second conductivity-type GaInP intermediate layer (not shown), and a second conductivity-type GaP window layer 41E are epitaxially grown in sequence. Composition and thickness of each layer are as described above. Consequently, the first structure 41 can be obtained as shown in FIGs. 14, 15, 17 and 18.

In this case, on a part other than the forming region 23 of the bridge portion 43 in the region 22 for forming the second structure 42, each of the epitaxial layers (a sacrificial layer 42A, a first cladding layer 42B, an active layer 42C, a second cladding layer 42D, an intermediate layer (not shown), and a window layer 42E) is also epitaxially grown in sequence. Consequently, the stacked portion 42F can be obtained as shown in FIGs. 14, 15, and 17.

In addition, on the region 23 for forming the bridge portion 43 in the region 22 for forming the second structure 42, a sacrificial layer 43A and a stacked portion 43F are also epitaxially grown in sequence. Consequently, the bridge portion 43 can be obtained as shown in FIGs. 14, 16, 17, and 19.

When growing the epitaxial layer, {111} planes 4A with slow growth speed appear along with a growth of (001) planes by set a V/III ratio as 50 or less; thus, the epitaxial layer structure 4 in pyramid-shape or truncated pyramid-shape can be formed. Moreover, by setting the V/III ratio as 1 or more, degradation of crystallinity due to stoichiometry imbalance can be prevented. The V/III ratio is more preferably 10 or more.

Specifically, the first structure 41 and the stacked portion 42F can be obtained as the epitaxial layer structures in the truncated pyramid shape, as shown in FIGs. 14, 15, and 17. As shown in FIG. 15, a total thickness of the first structure 41 in a direction perpendicular to a surface of the starting substrate 2 is Lh. Moreover, as shown in FIG. 17, T is a sum of the thicknesses of each of the first structure 41 and the stacked portion 42F of epitaxial layer structure 4, up to each of the active layer 41C and the active layer 42C, in a direction perpendicular to the surface of the starting substrate 2. Moreover, the bridge portion 43 can be obtained as the epitaxial layer structures in the truncated pyramid shape, as shown in FIGs. 14, 16, and 17.

FIG. 18 shows an enlarged view in the vicinity of the {111} plane (slope) 4A portion of the first structure 41 which is the light-emitting device portion. In this embodiment, the stacked portion 42F of the second structure 42, as the non-light-emitting device portion, is similar because the size is the same. The width of the opening 31 to expose each of the region 21 for forming the first structure 41 and the region for forming the stacked portion 42F of the region 22 for forming the second structure 42 is set in advance so as to enable all epitaxial layers up to each of window layers 41E and 42E to be stacked in accordance with designed thickness in the [001] direction, and thus the epitaxial layers are grown in such a way. On the other hand, the {111} planes 4A, as the slopes, have a stacked structure of the same kind and the same sequence with the [001] direction, as shown in FIG. 18; however, the growth speed of the {111} planes is less than one-fiftieth of that of the (001) planes when the V/III ratio is 50 or less; for example, when the V/III ratio is set to 30, the layer in the slope direction becomes an ultra-thin layer and fully depleted. FIG. 18 shows as if layers from the active layer to the window layer have a certain thickness, but this is for the sake of convenience.

An enlarged view of a slope including an apex of the bridge portion 43 is shown in FIG. 19. As in a case of FIG. 18, the {111} plane 4A, which is the slope of the laminate portion 43F, includes layers (the sacrificial layer 43A, the first cladding layer 43B, the active layer 43C, the second cladding layer 43D, the intermediate layer (not shown) and the window layer 43E) containing each of all materials of the epitaxial layers included in the first structure 41 (the sacrificial layer 41A, the first cladding layer 41B, the active layer 41C, the second cladding layer 41D, the intermediate layer (not shown) and the window layer 41E); however, by designing the opening width W in advance so as to make the apex of the pyramid-shape of the stacked portion 43F to reach above the first cladding layer 43B, the layers above the active layer 43C are thin films because only {111} planes are grown, and this is a difference from the structure shown in FIG. 18. That is, the {111} planes of the second conductivity-type layer have the thin film to be a full depletion layer; thus the bridge portion 43 behaves virtually as the first conductivity-type structure.

Next, an electrode made of a material that forms ohmic to a second conductivity-type semiconductor is formed on the GaP window layer 41E portion of the first structure 41 which is the light-emitting device portion. An electrode made of a material that forms ohmic to a first conductivity-type semiconductor is formed on the second structure 42 which is the non-light-emitting device portion. The electrodes thus formed are the electrodes 5 and 6 shown in FIGS. 1 and 2. With regard to the details of the electrodes 5 and 6, the previous description should be referred.

The electrodes of different polarity are thus formed on the first structure 41 and the second structure 42, respectively, to manufacture a wafer 1 having a micro-LED structure 7 operable as one micro-LED, which is constituted by the first structure 41 and the second structure 42, shown in FIGs. 1 and 2. That is, according to the manufacturing method described above, the inventive wafer 1 having a micro-LED structure 7 can be manufactured.

In addition, as described earlier, the inventive wafer 1 having a micro-LED structure 7 can have a variety of modifications, and a design change can be performed by simply changing, for example, a size and a design of the mask pattern of the mask 3.

Moreover, wafer 1 without a mask, as shown in FIG. 11, can be obtained by, for example, manufacturing the wafer 1 having a micro-LED structure 7 according to the method described above, then forming a resist mask or a hard mask on a portion other than the mask 3 by photolithography and removing the mask 3 according to an appropriate method.

### [Method for Manufacturing Bonded Semiconductor Wafer having micro-LED Structure]

Hereinafter, referring to FIGs. 20 to 27, an example of the inventive method for manufacturing a bonded semiconductor wafer having a micro-LED structure is described.

First, a wafer 1 having a micro-LED structure 7, shown in FIGs. 1 and 2, is manufactured according to the method described earlier with reference to FIGs. 12 to 19.

Next, as shown in FIG. 20, a surface where the micro-LED structure 7 of the wafer 1 is formed is coated with, for example, benzocyclobutene (BCB) of about 0.6 um as a bonding material 11. The thickness of BCB is not limited to this condition, and the same effect can be obtained with a thicker or thinner thickness. Moreover, the bonding material 11 is not limited to BCB and other bonding material may be used.

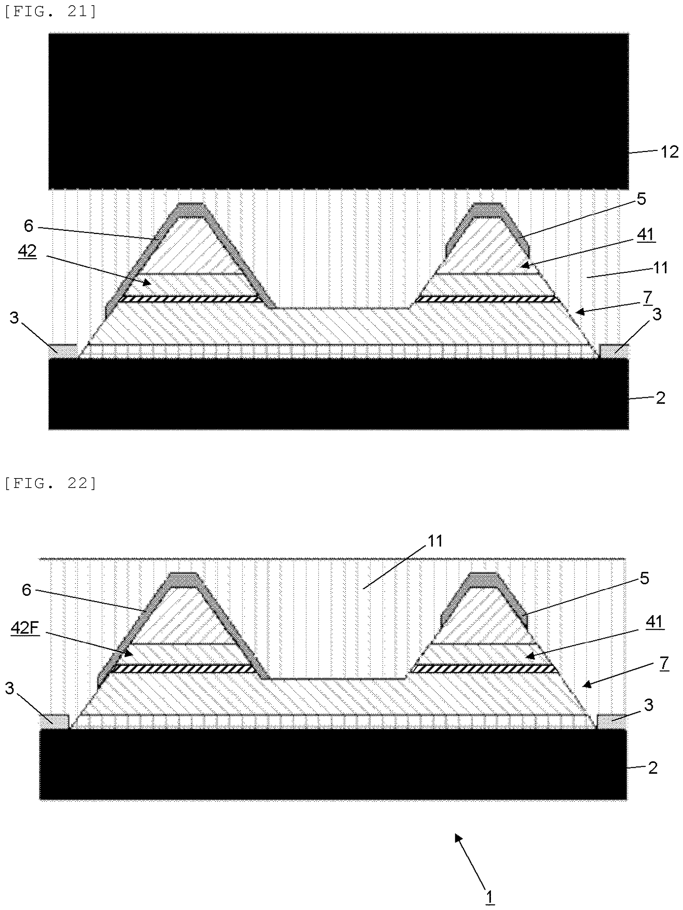

After the coating of BCB, as shown in FIG. 21, a substrate 12 for flattening treatment is pressed against the layer of the bonding material 11 to perform flattening treatment. In this embodiment, a case in which heating treatment is not performed is exemplified, but pressuring treatment may be performed with heating up to a range to a temperature (150°C) in which BCB is not cured.

After the flattening treatment, the flattening treatment substrate 12 is removed as shown in Fig. 22, and BCB curing treatment is performed by, for example, maintaining the temperature at 250°C for 1 hour.

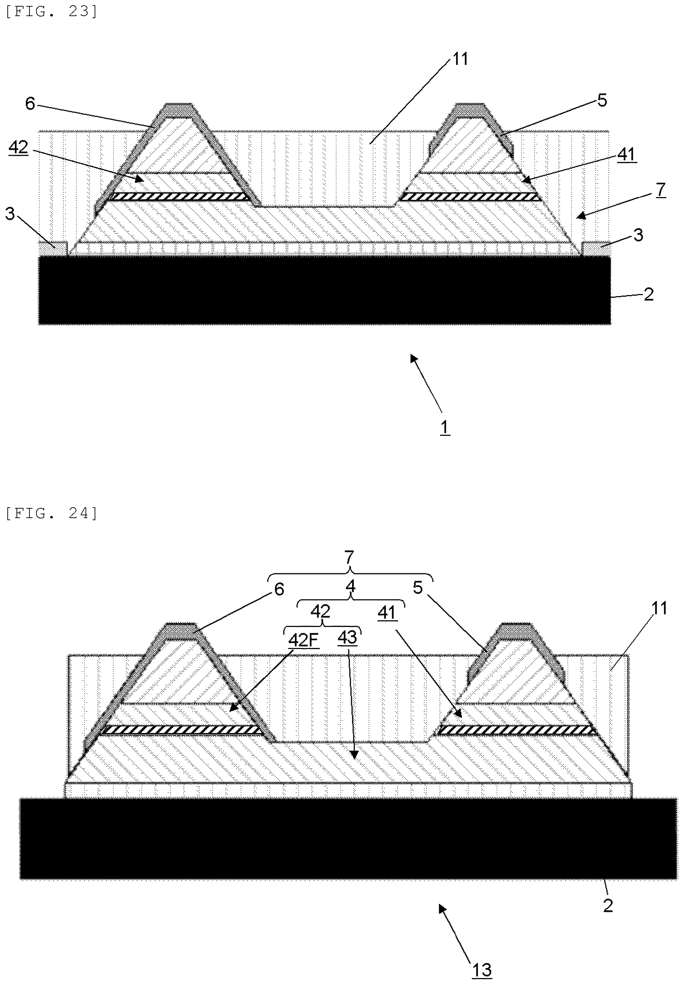

After the BCB curing treatment, ICP dry etching treatment is performed with fluorine-based plasma. In this embodiment, the coating of BCB is performed under a condition of the BCB thickness of 0.6 um, and then the flattening treatment is performed; thus, by performing the dry etching under a condition equivalent to an etching condition of 0.1 um for a flat plate, the BCB, which coats the apexes of the first structure 41 and stacked portion 42F each of which is the pyramidal shape portion, is etched to expose the electrodes 5 and 6, as shown in FIG. 23.

After exposing the electrodes, the resist mask or the hard mask is formed by photolithography, and then BCB (bonding material ) 11 in a region where the devices are to be isolated from each other is removed by fluorine-based plasma to form the substrate 13 for device-isolation processing, as shown in FIG. 24. In this case, the portion of the mask 3 formed around the periphery of the starting substrate 2 is also removed.

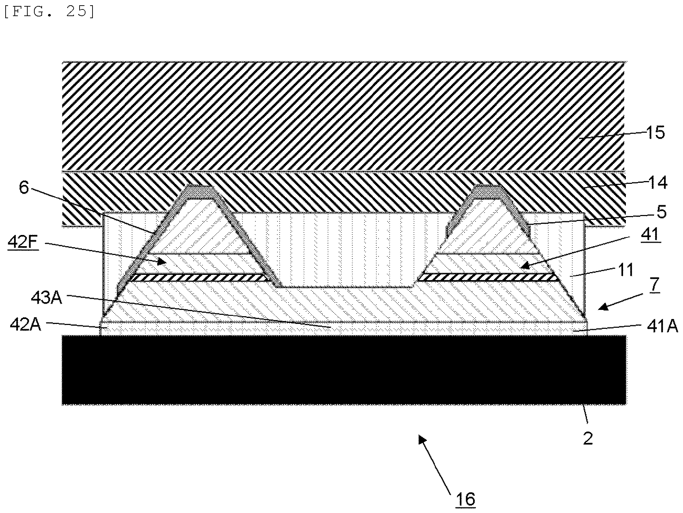

Next, an adhesive layer 14, such as a silicone adhesive layer, is formed on one of the main surfaces of a support substrate 15, such as a quartz substrate. The silicone adhesive layer 14 is then adhesively bonded to the exposed surfaces of the electrodes 5 and 6 of the substrate 13 for device-isolation processing to obtain a bonded substrate 16, as shown in FIG. 25.

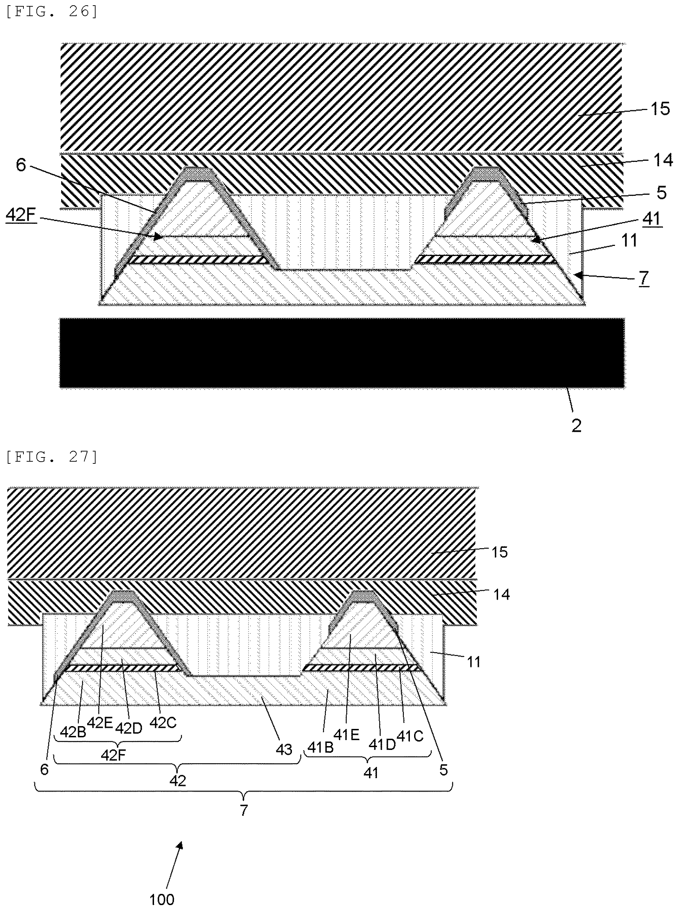

After the adhesive bonding, at least sacrificial layers 41A, 42A, and 43A of the bonded substrate 16 are immersed in HF, and a sacrificial layer etching is performed, as shown in FIG. 26, to separate the start substrate 2.

By removing the separated starting substrate 2, a bonded semiconductor wafer 100 having a micro-LED structure 7 shown in FIG. 27 is manufactured.

In the inventive method for manufacturing the bonded semiconductor wafer 100 described above, the process for the device isolation or the process such as the electrode-formation process to the micro-LED structure 7 is unnecessary. Thus, according to the inventive method for manufacturing the bonded semiconductor wafer having the micro-LED structure, the micro-LED 7, in which brightness decrease due to damage originated by the processing is suppressed, can be provided.

### EXAMPLES

Hereinafter, the present invention will be specifically described in detail with reference to Example and Comparative Example. However, the present invention is not limited thereto.

### (Example 1)

In Example 1, to begin with, a wafer having a micro-LED structure was manufactured by following procedures.

As described earlier with reference to FIGs. 12 and 13, a mask 3 of SiO₂ having a mask pattern including an opening 31 was formed on an N-type GaAs starting substrate 2 to obtain a patterned substrate 2.

In the opening 31, a portion corresponding to a region 21 for forming a first structure 41 was made to have rectangular planar shape, a portion corresponding to a region 22 for forming a second structure 42 was made to have a region where all corners were at right angles (90°), and then each side of the opening 31 was arranged almost parallel or perpendicular to a [100] direction.

A width Lws of a part of the opening for the first structure 41, as a light-emitting device portion, was set to 10 µm, a width W of an opening of a bridge portion 43 was set to 2.5 um, and a width of the opening of the laminate portion 42F, as the non-light-emitting device portion, was set to 10 µm.

On the region 21 for forming the first structure 41 in a portion 20 exposed through the opening 31 of such a patterned substrate 2, an n-type GaAs buffer layer (not shown) having a thickness of 0.5 um is stacked, and then a first conductivity-type AlAs sacrificial layer 41A having a thickness of 0.5 um, a first conductivity-type (Al_{y}Ga_{1-y})ₓIn₁₋ₓP (x:0.5; y:0.85) first cladding layer 41B having a thickness of 1.0 um, a non-doped (Al_{y}Ga_{1-y})ₓIn₁₋ₓP (x:0.5; y:0.1) active layer 41C having a thickness of 0.25 um, a second conductivity-type (Al_{y}Ga_{1-y})ₓIn₁₋ₓP (x:0.5; y:0.85) second cladding layer 41D having a thickness of 0.75 um, a second conductivity-type GaInP intermediate layer (not shown) having a thickness of 0.1 um, and a second conductivity-type GaP window layer 41E having a thickness of 1.9 um were epitaxially grown in sequence, as shown in FIGs. 14, 15, 17 and 18. A raw material V/III ratio during growth was set to 30.

At the same time, also on a portion in the region 22 for forming the second structure 42 other than a region 23 for forming the bridge portion 43; each epitaxial layer (a sacrificial layer 42A, a first cladding layer 42B, an active layer 42C, a second cladding layer 42D, an intermediate layer (not shown) and a window layer 42E) was epitaxially grown sequentially. Thus, the stacked portion 42F shown in FIGs. 14, 15, 17 and 18 was obtained.

Furthermore, at the same time, also on the region 23 for forming the bridge portion 43 in the region 22 for forming the second structure 42, a sacrificial layer 43A and a stacked portion 43F were epitaxially grown sequentially. Thus, the bridge portion 43 shown in FIGs. 14, 16, 17 and 19 was obtained.

Next, as shown in FIGs. 1 and 2, an electrode 6, which was an N-type electrode, was formed from an apex portion of the stacked portion 42F to the bridge portion 43 of the second structure 42, as the non-light-emitting device portion. With regard to the N-type electrode 6, a metal including Au as a main material and Ge was used. On the other hand, as shown in FIGs. 1 and 2, a P-type electrode 5 was formed only on the P-type GaP window layer 41E of the first structure 41. With regard to the P-type electrode, a metal including Au as the main material and Be was used.

As described above, a wafer 1 having a micro-LED structure 7 shown in FIGs. 1 and 2 was obtained. Using this wafer 1, a bonded semiconductor substrate having a micro-LED structure was manufactured in a following procedure.

First, as shown in FIG. 20, BCB, as a bonding material 11, was coated under a condition to have a film thickness of 0.6 um on a flat surface of the wafer 1. After the BCB coating, a substrate 12 for flattenining treatment was pressed to the material 11 with a pressure of 10 N/cm² at room temperature to perform a flattening treatment as shown in FIG. 21. Then, the wafer was kept at 250°C for 1 hour to perform BCB curing treatment, resulting in a state shown in FIG. 22.

After the BCB curing treatment, ICP dry etching treatment with fluorine-based plasma was performed under a condition equivalent to an etching condition of 0.1 um on a flat plate. Through performing the dry etching, BCB at the apexes of the first structure 41 and the laminate portion 42F in pyramidal-shape portions were etched to expose the electrodes 5 and 6 as shown in FIG. 23.

After exposing the electrode potions, a resist mask or a hard mask was formed by photolithography, and BCB in a region where the devices are to be isolated from each other was removed by fluorine-based plasma to form a substrate 13 for device-isolation processing, as shown in FIG. 24.

Next, a silicone adhesive layer 14 was formed on one of main surfaces of a quartz substrate which was a support substrate 15, and the silicone adhesive layer 14 was adhesively bonded to a surface of the substrate 13 for device-isolation processing where the electrodes 5 and 6 were exposed to obtain a bonded substrate 16 shown in FIG. 25.

After the adhesive bonding, the substrate 16 was immersed in HF and sacrificial layer etching was performed to separate the starting substrate 2, as shown in FIG. 26.

By removing the separated starting substrate 2, a bonded semiconductor wafer 100 having a micro-LED structure 7 shown in FIG. 27 was manufactured.

### (Comparative Example)

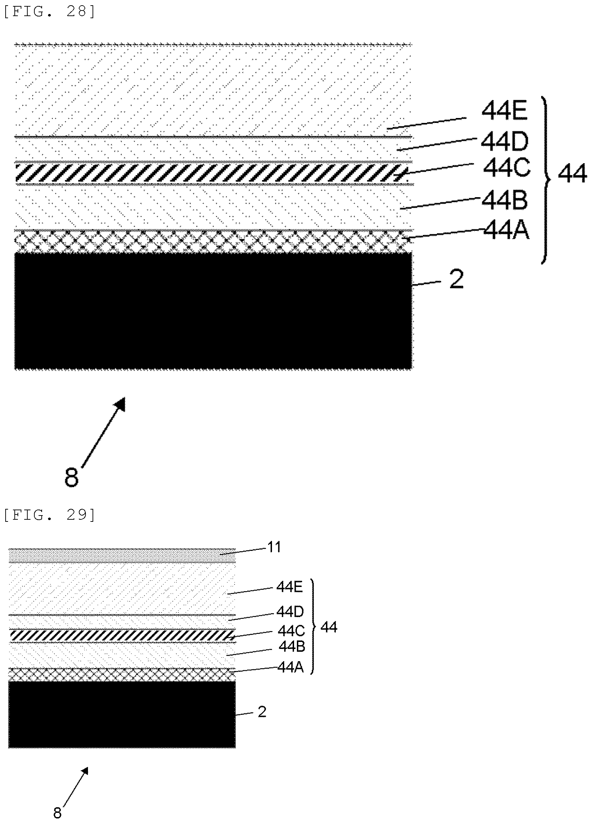

In Comparative Example, a bonded semiconductor wafer was manufactured in a following procedure described with reference to FIGs. 28 to 35.

First, as shown in FIG. 28, an N-type GaAs buffer layer (not shown) having a thickness of 0.5 um was stacked on an N-type GaAs substrate 2 which has no mask pattern, and then an N-type GaₓIn₁₋ₓP (x:0.5) first sacrificial layer having a thickness of 0.3 um and an N-type GaAs second sacrificial layer having a thickness of 0.3 um were epitaxially grown to make a sacrificial layer 44A; on this sacrificial layer 44A, an N-type (Al_{y}Ga_{1-y})ₓIn₁₋ₓP (x:0.5; y:0.85) first cladding layer 44B having a thickness of 1.0 um, a non-doped (Al_{y}Ga_{1-y})ₓIn₁₋ₓP (x:0.5; y:0.1) active layer 44C having a thickness of 0.25 um, a P-type (Al_{y}Ga_{1-y})ₓIn₁₋ₓP (x:0.5; y:0.85) second cladding layer 44D having a thickness of 1.0 um, a P-type GaInP intermediate layer (not shown) having a thickness of 0.1 um, and a P-type GaP window layer 44E having a thickness of 4.0 um were epitaxially grown sequentially to provide an epitaxial wafer (EPW) 8 having light-emitting device structure 44 shown in FIG. 28.

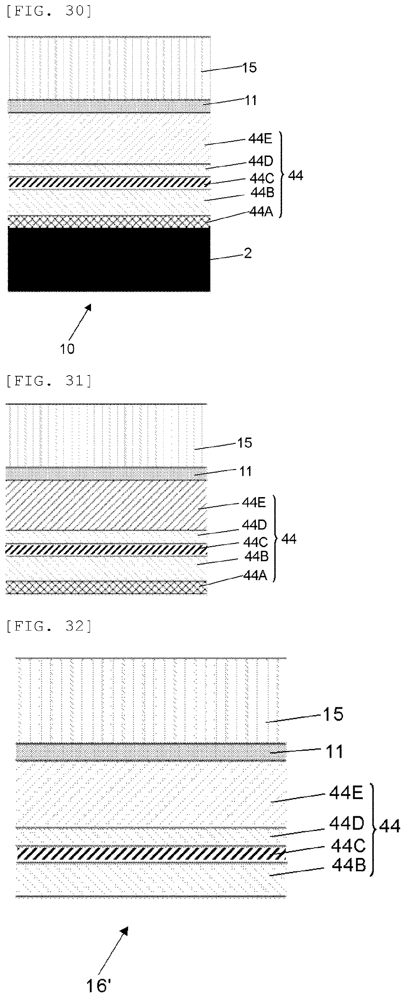

Next, on the epitaxial wafer 8, benzocyclobutene (BCB) was spin-coated as the thermosetting bonding material 11 with a designed film thickness of 0.6 um as shown in FIG. 29, and then BCB and a sapphire substrate as a support substrate 15 were faced each other, superimposed, and thermocompression bonded to produce an epitaxial wafer (EPW) bonded substrate 10 shown in FIG. 30.

Next, the GaAs starting substrate 2 was removed by wet etching to expose the first sacrificial layer as shown in FIG. 31, and then an etchant was switched and the sacrificial layer 44A made up of the first sacrificial layer and the second sacrificial layer, respectively, were removed to expose the first cladding layer 44B, thereby producing an epitaxial (EP) bonded substrate 16' shown in FIG. 32.

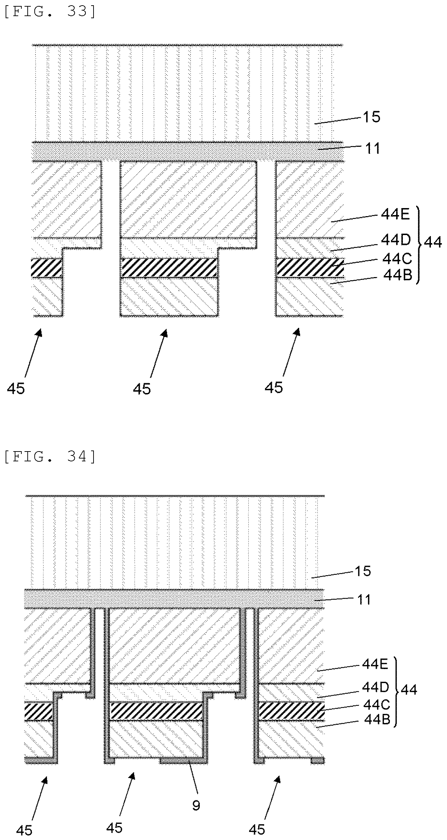

Next, a mask was formed on the EP bonded substrate 16' (lower side in the drawing) by a photolithography method, and then a part of each of the layers from the first cladding layer 44B to the GaP window layer 44E was etched. Thus, a device-isolation step to form an island-shaped devices and an etching step to expose a part of the second cladding layer 44D were performed. Owing to these steps, a plurality of island-shaped devices 45 shown in FIG. 33 was obtained.

Next, a passivation (PSV) film 9 made of SiO₂ was formed on a surface of the island-shaped device 45. The PSV film 9 was formed using a TEOS+O₂-based P-CVD apparatus and a film thickness was set to 0.4 um. The PSV 9 was processed so as to expose a part of each of the first cladding layer 44B and the second cladding layer 44D as shown in FIG. 34.

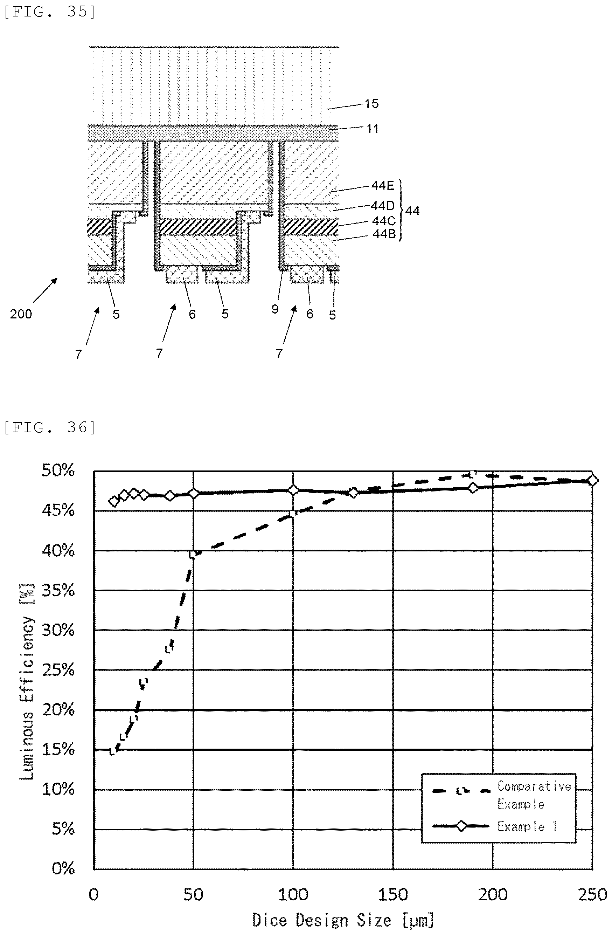

Next, as shown in FIG. 35, each of electrodes 5 and 6 was formed on a part of each of the first cladding layer 44B and the second cladding layer 44D exposed through an opening of the PSV film 9, then heat treatment was performed to realize an ohmic contact. The electrodes 5 and 6 in this regard were the same as in Example.

With the procedure above, a bonded semiconductor wafer 200 having a plurality of micro-LED structures 7, as shown in FIG. 35, was obtained.

### (Evaluation)

In Example 1 described above, a size of one side of the first structure 41, which was a light-emitting device portion, was changed from 10 to 250 um to manufacture a plurality of bonded semiconductor wafers 100. In this case, the size of one side of the first structure 41 was changed by varying the width Lws of one side of the square opening for the first structure 41 from 10 to 250 um, while the thickness of each layer in the laminating direction and the opening width W (= 2.5 um) for the bridge portion 43 were fixed.

In the same way, in Comparative Example described above, a size of one side of the island-shaped device 45 was changed from 10 to 250 um to manufacture a plurality of bonded semiconductor wafers 200.

FIG. 36 shows a relation between the size of one side (dice design size) of the first structure 41 or the island-shaped device 45, which are the light-emitting device portions, and external quantum efficiency (luminous efficiency) at a current density of 8 [A/cm²] for Example 1 and Comparative Example. In the case of Example 1, the dice design size corresponded to a length of one side of the opening (in square) for the light-emitting device portion of a mask pattern in a mask 3. In addition, when an area was changed, the current was changed so as to maintain the current density at 8 A/cm². Luminous efficiency was calculated by optical output [W] / input power [W].

As clear from FIG. 36, in Comparative Example, the luminous efficiency significantly decreases as the size of the island-shaped device 45, which is the light-emitting device, decreases. This is considered to be caused by damage inflicted on the light-emitting device portion due to device-isolation processing and subsequent device processing.

On the other hand, in Example 1, even when the size of the first structure 41 is smaller than 100 um or less, which is a size of a typical micro-LED level, a significant luminous efficiency decrease does not occur.

In the inventive wafer 1 having a micro-LED structure 7, device processing after epitaxial growth is not required in principle; thus, no cross-section generated by processing is present. Thus, it is characterized in that outer surfaces of an epitaxial layer structure 4 are constituted solely by an epitaxial surface. Therefore, the first structure 41, which is the light-emitting device portion, has no damage due to processing.

In addition, the inventive wafer 1 having a micro-LED structure 7 has no processing damage, resulting in no need for a damage-removing step. Moreover, in a process of epitaxial growth, for example, as shown in FIG. 18, the surface is coated with a thin film portion of the window layer 41E which also has an effect similar to a passivation layer; even when a passivation film is not formed, a surface state reduction effect is exhibited in a similar way in which the passivation layer is formed; therefore, a photon absorbed by the surface state is decreased, resulting in suppressing decrease in luminous efficiency compared to a conventional art.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A wafer having a micro-LED structure, the wafer comprising:
a starting substrate;
a mask formed on the starting substrate and having a mask pattern including an opening; and
a plurality of epitaxial layer structures, each of the plurality of structures selectively grown on a portion corresponding to the opening of the mask pattern on the starting substrate,
wherein each of the plurality of the epitaxial layer structures has a pyramid-shape or a truncated pyramid-shape surrounded by {111} planes,
the plurality of epitaxial layer structures includes a first structure, as a light-emitting device portion, and a second structure connected to the first structure, and
a polarity of an electrode of the first structure is different from that of an electrode of the second structure, and the first structure and the second structure constitute a micro-LED structure operable as one micro-LED, and the plurality of the epitaxial layer structures have thin films which are full depletion layers in {111} plane directions.

2. The wafer having a micro-LED structure according to claim 1,
wherein, the first structure is the light-emitting device portion having an AlGaInP-based light-emitting layer and Lh ≤ 0.707 × Lws where a width of a shortest portion at a bottom is Lws, and a total thickness of the first structure in a direction perpendicular to a surface of the starting substrate is Lh.

3. The wafer having a micro-LED structure according to claim 2,
wherein the width Lws of the shortest portion at the bottom of the first structure is 10 um or more and 100 um or less.

4. The wafer having a micro-LED structure according to any one of claims 1 to 3,
wherein, the epitaxial layer structure includes an active layer, the second structure is a non-light-emitting device portion and includes a pyramid-shape bridge portion at least partially, and 1.5 um < W < T/0.707 where a width of a shortest part of the bridge portion is W [pm] and a sum of thicknesses of the epitaxial layer structure up to the active layer in the direction perpendicular to the surface of the starting substrate is T [um].

5. A wafer having a micro-LED structure, the wafer comprising:
a starting substrate; and
a plurality of epitaxial layer structures each of which is selectively grown on a portion of the starting substrate,
wherein each of the plurality of the epitaxial layer structures has a pyramid-shape or a truncated pyramid-shape surrounded by {111} planes,
the plurality of epitaxial layer structures includes a first structure, as a light-emitting device portion, and a second structure connected to the first structure, and
a polarity of an electrode of the first structure is different from that of an electrode of the second structure, and the first structure and the second structure constitute a micro-LED structure operable as one micro-LED, and the plurality of the epitaxial layer structures have thin films which are full depletion layers in {111} plane directions.

6. A method for manufacturing a wafer having a micro-LED structure, the method comprising:
providing a starting substrate;
forming a mask having a mask pattern including an opening on the starting substrate;
selectively growing a plurality of epitaxial layer structures, including a first structure as a light-emitting device portion and a second structure connected to the first structure, on a portion exposed through the opening of the mask pattern on the starting substrate, such that each of the plurality of the epitaxial layer structures has a pyramid-shape or a truncated pyramid-shape surrounded by {111} planes and the plurality of the epitaxial layer structures has thin films which are as full depletion layers in {111} plane directions; and
forming electrodes of different polarities to the first structure and the second structure, respectively, to manufacture a wafer having a micro-LED structure including the first structure and the second structure and operable as one micro-LED.

7. A method for manufacturing a bonded semiconductor wafer having a micro-LED structure, the method comprising:
manufacturing a wafer having a micro-LED structure by the method for manufacturing a wafer having a micro-LED structure according to claim 6;
bonding a surface of the wafer where the micro-LED structure is formed to one of main surfaces of a support substrate via a bonding material to obtain a bonded substrate; and
removing the starting substrate from the bonded substrate to manufacture a bonded semiconductor wafer having the micro-LED structure.
